# EUROPÄISCHE PATENTSCHRIFT

(11) **EP 2 599 123 B1**
(45) Veröffentlichungstag und Bekanntmachung des Hinweises auf die Patenterteilung: **12.06.2019**
(21) Anmeldenummer: 11745501.4
(22) Anmeldetag: 13.07.2011
(51) Int. Cl.: H01L 27/15, H01L 33/62

(54) **VERFAHREN ZUR HERSTELLUNG EINES OPTOELEKTRONISCHEN HALBLEITERBAUTEILS UND OPTOELEKTRONISCHES HALBLEITERBAUTEIL**
METHOD FOR PRODUCING AN OPTOELECTRONIC SEMICONDUCTOR COMPONENT, AND OPTOELECTRONIC SEMICONDUCTOR COMPONENT
PROCÉDÉ DE FABRICATION D'UN ÉLÉMENT SEMI-CONDUCTEUR OPTOÉLECTRONIQUE ET ÉLÉMENT SEMI-CONDUCTEUR OPTOÉLECTRONIQUE

(30) Priorität: 30.07.2010 DE 102010032813
(43) Veröffentlichungstag der Anmeldung: 05.06.2013
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/EP2011/061987
(87) Internationale Veröffentlichungsnummer: WO 2012/013500

(56) Entgegenhaltungen:
- EP-A2- 0 933 842
- EP-A2- 1 601 019
- DE-A1-102004 058 732
- DE-A1-102007 022 947
- DE-A1-102009 006 177
- US-A1- 2006 060 880

## Beschreibung

Verfahren zur Herstellung eines optoelektronischen Halbleiterbauteils und optoelektronisches Halbleiterbauteil Es wird ein Verfahren zur Herstellung eines optoelektronischen Halbleiterbauteils angegeben. Darüber hinaus wird ein optoelektronisches Halbleiterbauteil angegeben.

Eine zu lösende Aufgabe besteht darin, ein Verfahren zur Herstellung eines optoelektronischen Halbleiterbauteils anzugeben, das besonders kostengünstig ist.

Ein erfindungsgemäßes Verfahren ist spezifiziert durch die Merkmale des Anspruchs 1. Ein erfindungsgemäßes Halbleierbauteil ist spezifiziert durch die Merkmale des Anspruchs 4. Vorteilhafte Ausgestaltungen und Weiterbildungen sind Gegenstand der abhängigen Ansprüche.

Im Folgenden werden Teile der Beschreibung und Zeichnungen, die sich auf Ausführungsformen und Ausführungsbeispiele beziehen, die nicht von den Ansprüchen abgedeckt sind, nicht als Ausführungsformen und Ausführungsbeispiele der Erfindung präsentiert, sondern als Beispiele, die zum Verständnis der Erfindung nützlich sind.

Gemäß dem erfinderischen Verfahren zur Herstellung eines optoelektronischen Halbleiterbauteils wird in einem ersten Verfahrensschritt ein Halbleiterschichtenstapel, der einen pn-Übergang umfasst, auf einem Substrat angeordnet. Beispielsweise wird der Halbleiterschichtenstapel epitaktisch auf dem Substrat abgeschieden. Der Halbleiterschichtenstapel umfasst dabei vorzugsweise zumindest eine n-leitende Schicht und eine p-leitende Schicht. Zwischen der n-leitenden Schicht und der p-leitenden Schicht ist der pn-Übergang angeordnet. Der pn-Übergang umfasst vorzugsweise zumindest einen aktiven Bereich, der zur Erzeugung oder zur Detektion elektromagnetischer Strahlung vorgesehen ist.

Beispielsweise basiert der Halbleiterschichtenstapel auf einem III/V-Verbindungs-Halbleitermaterial, das wenigstens ein Element aus der dritten Hauptgruppe wie beispielsweise Al, Ga, In, und ein Element aus der fünften Hauptgruppe, wie beispielsweise N, P, As, aufweist. Insbesondere umfasst der Begriff III/V-Verbindungs-Halbleitermaterial die Gruppe der binären, ternären und quarternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. N-leitende beziehungsweise p-leitende Schichten können durch entsprechende Dotierung des Halbleitermaterials erzeugt werden.

Bei dem Substrat handelt es sich beispielsweise um ein Aufwachssubstrat, das vorliegend unter anderem aus Saphir oder Silizium bestehen kann oder Saphir oder Silizium enthalten kann.

Gemäß zumindest einer Ausführungsform des Verfahrens wird der Halbleiterschichtenstapel nach seinem Aufbringen auf dem Substrat lateral in eine Vielzahl von Paaren erster Halbleiterkörper und zweiter Halbleiterkörper strukturiert. Laterales Strukturieren heißt dabei, dass der Halbleiterschichtenstapel in die Vielzahl von Paaren erster Halbleiterkörper und zweiter Halbleiterkörper aufgeteilt wird, wobei die Paare in lateraler Richtung beabstandet zueinander sind. Die laterale Richtung ist dabei diejenige Richtung, die zu der Außenfläche des Substrats, auf welcher der Halbleiterschichtenstapel angeordnet ist, parallel verläuft.

Beispielsweise sind auch die ersten und zweiten Halbleiterkörper jedes Paars nach dem lateralen Strukturieren in lateraler Richtung beabstandet zueinander angeordnet. Das heißt, zwischen dem ersten Halbleiterkörper und dem zweiten Halbleiterkörper befindet sich dann ein Graben, der sich von der dem Substrat abgewandten Oberseite des Halbleiterschichtenstapels bis zum Substrat oder bis in das Substrat hinein erstrecken kann. Die Strukturierung kann dabei beispielsweise mittels Ätzens von Mesagräben und/oder einem Lasertrennverfahren erfolgen. Durch die laterale Strukturierung des Halbleiterschichtenstapels entstehen erste Halbleiterkörper und zweite Halbleiterkörper, die jeweils einen Bereich des pn-Übergangs des Halbleiterschichtenstapels umfassen. Das heißt, erster Halbleiterkörper und zweiter Halbleiterkörper weisen jeweils auch einen pn-Übergang auf. Nach dem lateralen Strukturieren sind die pn-Übergänge von erstem und zweiten Halbleiterkörper eines jeden Paares elektrisch voneinander isoliert.

Gemäß dem erfinderischen Verfahren wird das Substrat von den Paaren erster Halbleiterkörper und zweiter Halbleiterkörper abgelöst. Das Ablösen des Substrats erfolgt dabei nach der lateralen Strukturierung des Halbleiterschichtenstapels in die Vielzahl von Paaren erster Halbleiterkörper und zweiter Halbleiterkörper. Das Ablösen kann beispielsweise mittels Ätzens, Sägens, Schleifens und/oder einem Laser-Lift-Off-Verfahren erfolgen.

Gemäß dem erfinderischen Verfahren wird zumindest ein Paar erster Halbleiterkörper und zweiter Halbleiterkörper auf einen Anschlussträger aufgebracht. Das Aufbringen des Paares erster Halbleiterkörper und zweiter Halbleiterkörper kann dabei vor oder nach dem Ablösen des Substrats erfolgen. Der erste und der zweite Halbleiterkörpers eines Paares werden dabei vorzugsweise gleichzeitig, also im gleichen Arbeitsschritt auf den Anschlussträger aufgebracht.

Bei dem Anschlussträger handelt es sich beispielsweise um eine Art Leiterplatte, welche elektrische Anschlussstellen und/oder zumindest eine Leiterbahn aufweist. Beispielsweise umfasst der Anschlussträger einen keramischen Grundkörper, an dessen Außenfläche die elektrischen Anschlussstellen und/oder die zumindest eine Leiterbahn beispielsweise in Form von strukturierten Metallisierungen aufgebracht sind. Der keramische Grundkörper kann insbesondere aus einem keramischen Material wie Siliziumnitrid, Aluminiumoxid oder Bornitrid bestehen oder eines dieser keramischen Materialien enthalten. Darüber hinaus ist es möglich, dass es sich bei dem Anschlussträger um eine Metallkernplatine oder eine bedruckte Leiterplatte, beispielsweise auch eine flexible bedruckt Leiterplatte handelt. Der Anschlussträger weist in jedem Fall elektrische Anschlussstellen und zumindest eine Leiterbahn auf.

Gemäß dem erfinderischen Verfahren werden die Halbleiterkörper eines Paares erster Halbleiterkörper und zweiter Halbleiterkörper mittels der Anschlussstellen und der zumindest einen Leiterbahn des Anschlussträgers derart elektrisch miteinander verbunden, dass der pn-Übergang des ersten Halbleiterkörpers zum pn-Übergang des zweiten Halbleiterkörpers antiparallel geschaltet ist.

"Antiparallel" geschaltet heißt dabei, dass erster Halbleiterkörper und zweiter Halbleiterkörper derart parallel zueinander geschaltet sind, dass der p-leitende Bereich des ersten Halbleiterkörpers mit dem n-leitenden Bereich des zweiten Halbleiterkörpers und der n-leitende Bereich des ersten Halbleiterkörpers mit dem p-leitenden Bereich des zweiten Halbleiterkörpers elektrisch verbunden ist. Aufgrund der pn-Übergänge bilden der erste Halbleiterkörper und der zweite Halbleiterkörper Dioden, die mittels der Anschlussstellen und/oder der zumindest einen Leiterbahn des Anschlussträgers antiparallel zueinander geschaltet sind. Das elektrische Verbinden der Halbleiterkörper erfolgt dabei mit oder nach dem Aufbringen eines Paares erster Halbleiterkörper und zweiter Halbleiterkörper auf den Anschlussträger. Das elektrische Verbinden erfolgt insbesondere nicht vor dem Aufbringen auf den Anschlussträger. Vor dem Aufbringen auf den Anschlussträger sind die pn-Übergänge von erstem und zweitem Halbleiterkörper elektrisch voneinander getrennt.

Gemäß dem erfinderischen Verfahren wird die zumindest eine Leiterbahn zum elektrischen Verbinden des ersten Halbleiterkörpers mit dem zweiten Halbleiterkörper derart, dass die pn-Übergänge der Halbleiterkörper antiparallel zueinander geschaltet sind, erst nach dem Aufbringen und Testen des ersten Halbleiterkörpers geschlossen. Auf diese Weise stört der zweite Halbleiterkörper das Testen des ersten Halbleiterkörpers auf seine Funktionsfähigkeit hin nicht.

Es wird darüber hinaus ein optoelektronisches Halbleiterbauteil angegeben. Das optoelektronische Halbleiterbauteil kann mit dem hier beschriebenen Verfahren hergestellt werden, das heißt sämtliche für das Verfahren zur Herstellung des optoelektronischen Halbleiterbauteils offenbarten Merkmale sind auch für das optoelektronische Halbleiterbauteil offenbart und umgekehrt.

Erfindungsgemäss umfasst das optoelektronische Halbleiterbauteil einen Anschlussträger, der elektrische Anschlussstellen und zumindest eine Leiterbahn aufweist.

Darüber hinaus umfasst das optoelektronische Halbleiterbauteil einen ersten Halbleiterkörper, der einen pn-Übergang aufweist und einen zweiten Halbleiterkörper, der einen pn-Übergang aufweist. Dabei sind der erste Halbleiterkörper und der zweite Halbleiterkörper vorzugsweise gleichartig aufgebaut. "Gleichartig aufgebaut" heißt dabei, dass die Halbleiterkörper beispielsweise die gleiche Abfolge von Halbleiterschichten umfassen.

Im erfindungsgemässen optoelektronischen Halbleiterbauteil weisen der erste Halbleiterkörper und der zweite Halbleiterkörper die gleiche Dicke auf. Die Dicke wird dabei in einer vertikalen Richtung gemessen, die senkrecht zur lateralen Richtung verläuft. Unter der gleichen Dicke wird eine im Rahmen der Herstellungstoleranz beim epitaktischen Abscheiden eines Halbleiterschichtenstapels erreichbare gleiche Dicke verstanden. Ein erster Halbleiterkörper und ein zweiter Halbleiterkörper, die gleichartig aufgebaut sind und die gleiche Dicke aufweisen, können beispielsweise durch laterales Strukturieren eines Halbleiterschichtenstapels in eine Vielzahl von Paare erster Halbleiterkörper und zweiter Halbleiterkörper hergestellt werden.

Im erfindungsgemässen optoelektronischen Halbleiterbauteil sind der erste Halbleiterkörper und der zweite Halbleiterkörper in der gleichen Orientierung auf den Anschlussträger aufgebracht. Das heißt, beispielsweise ist bei beiden Halbleiterkörpern die n-leitende Schicht an der dem Anschlussträger abgewandten Seite des jeweiligen Halbleiterkörpers angeordnet. Die p-leitende Schicht der Halbleiterkörper ist dann jeweils dem Anschlussträger zugewandt.

Im erfindungsgemässen optoelektronischen Halbleiterbauteil sind der erste Halbleiterkörper und der zweite Halbleiterkörper mit zugeordneten elektrischen Anschlussstellen elektrisch leitend verbunden und der erste Halbleiterkörper und der zweite Halbleiterkörper sind mittels der elektrischen Anschlussstellen und der zumindest einen Leiterbahn derart miteinander verbunden, dass der pn-Übergang des ersten Halbleiterkörpers zum pn-Übergang des zweiten Halbleiterkörpers antiparallel geschaltet ist.

Erfindungsgemäss umfasst das Halbleiterbauteil einen Anschlussträger, der elektrische Anschlussstellen und/oder zumindest eine Leiterbahn aufweist. Weiter umfasst das Halbleiterbauteil einen ersten Halbleiterkörper, der einen pn-Übergang aufweist, und einen zweiten Halbleiterkörper, der einen pn-Übergang aufweist. Dabei sind der erste Halbleiterkörper und der zweite Halbleiterkörper gleichartig aufgebaut und weisen die gleiche Dicke auf. Der erste Halbleiterkörper und der zweite Halbleiterkörper sind mit zugeordneten elektrischen Anschlussstellen leitend verbunden und mittels der elektrischen Anschlussstellen und/oder der zumindest einen Leiterbahn des Anschlussträgers derart miteinander verbunden, dass der pn-Übergang des ersten Halbleiterkörpers zum pn-Übergang des zweiten Halbleiterkörpers antiparallel geschaltet ist.

Im erfindungsgemässen Halbleiterbauteil ist der erste Halbleiterkörper im Betrieb des Halbleiterbauteils zur Erzeugung von elektromagnetischer Strahlung vorgesehen. Beispielsweise handelt es sich bei dem ersten Halbleiterkörper dann um einen Leuchtdiodenchip.

Der zweite Halbleiterkörper ist erfindungsgemäss als ESD-Schutzdiode für den ersten Halbleiterkörper vorgesehen.

Dem hier beschriebenen Verfahren und dem hier beschriebenen Halbleiterbauteil liegt dabei unter anderen folgende Idee zugrunde: Mit dem beschriebenen Verfahren kann beispielsweise ein Leuchtdiodenchip - der erste Halbleiterkörper - und eine ESD-Schutzdiode - der zweite Halbleiterkörper - auf einem einzigen Wafer gefertigt werden. Die ESD-Schutzdiode wird dabei parallel zum Leuchtdiodenchip gefertigt. Abgesehen von der lateralen Strukturierung des Halbleiterschichtenstapels in erste und zweite Halbleiterkörper ist kein zusätzlicher Arbeitsschritt im Vergleich zur herkömmlichen Herstellung von Leuchtdiodenchips erforderlich. Dadurch ist die Herstellung einer ESD-Schutzdiode möglich, die besonders geringe Kosten in der Fertigung erzeugt. Ferner weist die ESD-Schutzdiode die gleiche Dicke wie der Leuchtdiodenchip auf, sodass ein besonders dünnes Halbleiterbauteil erzeugt werden kann, für welches beispielsweise ein besonders kostengünstiger Anschlussträger mit einem keramischen Grundkörper Verwendung finden kann. Darüber hinaus zeichnet sich das hier beschriebene Verfahren zur Herstellung eines Halbleiterbauteils dadurch aus, dass ein Testen des Leuchtdiodenchips auf dem Anschlussträger bei nicht angeschlossener ESD-Schutzdiode erfolgen kann, indem eine Verbindung zwischen erstem Halbleiterkörper und zweitem Halbleiterkörper erst nach dem Aufbringen und Testen der Halbleiterkörper auf den Anschlussträger erfolgt. Auf diese Weise kann sichergestellt werden, dass das Vorhandensein einer ESD-Schutzdiode die Messergebnisse eines Testens des Leuchtdiodenchips, also des ersten Halbleiterkörpers, weder stört noch verfälscht.

Gemäß zumindest einer Ausführungsform des optoelektronischen Halbleiterbauteils weist der erste Halbleiterkörper eine Grundfläche auf, die größer ist als eine Grundfläche des zweiten Halbleiterkörpers. Die Grundfläche ist dabei beispielsweise durch die Fläche der Halbleiterkörper an ihrer dem Anschlussträger abgewandten Seite in einer Ebene parallel zur Haupterstreckungsrichtung des Anschlussträgers gemessen. Insbesondere ist es möglich, dass sich der erste Halbleiterkörper und der zweite Halbleiterkörper hauptsächlich im Hinblick auf ihre unterschiedlichen Grundflächen voneinander unterscheiden.

Gemäß zumindest einer Ausführungsform ist die Grundfläche des zweiten Halbleiterkörpers höchstens 10 % der Grundfläche des ersten Halbleiterkörpers. Das heißt, der zweite Halbleiterkörper ist in Bezug auf seine laterale Ausdehnung wesentlich kleiner als der erste Halbleiterkörper. Beispielsweise weist der erste Halbleiterkörper eine Grundfläche von 1 mm x 1 mm auf. Der zweite Halbleiterkörper weist dann beispielsweise eine Grundfläche von 100 µm x 60 µm auf.

Gemäß zumindest einer Ausführungsform weisen der erste Halbleiterkörper und der zweite Halbleiterkörper eine Dicke von höchstens 10 µm, zum Beispiel von circa 6 µm auf. Mit anderen Worten sind die Halbleiterkörper besonders dünn ausgebildet, was dadurch erreicht werden kann, dass das Substrat vollständig vom die Halbleiterkörper umfassenden Halbleiterschichtenstapel abgelöst ist.

Gemäß zumindest einer Ausführungsform sind der erste Halbleiterkörper und der zweite Halbleiterkörper oberflächenmontierbar, wobei der erste Halbleiterkörper und der zweite Halbleiterkörper an ihrer dem Anschlussträger zugewandten Bodenfläche Kontaktstellen aufweisen. Beispielsweise kann sich von den Kontaktstellen zumindest eine Durchkontaktierung jeweils in den ersten Halbleiterkörper und den zweiten Halbleiterkörper erstrecken, die beispielsweise zur Kontaktierung des p-leitenden oder des n-leitenden Bereichs des Halbleiterkörpers vorgesehen ist.

Gemäß zumindest einer Ausführungsform weist der erste Halbleiterkörper an seiner dem Anschlussträger abgewandten Oberseite eine Strahlungsaustrittsfläche auf, durch die ein Großteil der vom ersten Halbleiterkörper im Betrieb erzeugten elektromagnetischen Strahlung tritt, wobei eine Stromverteilung zur Bestromung des pn-Übergangs des ersten Halbleiterkörpers vollständig unterhalb der Strahlungsaustrittsfläche erfolgt. Mit anderen Worten sind an der dem Anschlussträger abgewandten Oberseite des ersten Halbleiterkörpers keine Kontaktstellen oder Stromverteilungsbahnen angeordnet, welche austretende elektromagnetische Strahlung, zum Beispiel Licht, absorbieren oder reflektieren könnten. Der Halbleiterkörper ist daher an seiner Oberseite frei von Metallisierungen. Dies ist dadurch möglich, dass die Stromverteilung unterhalb der Strahlungsaustrittsfläche erfolgt.

Gemäß zumindest einer Ausführungsform ist zumindest eine Kontaktstelle des ersten Halbleiterkörpers und/oder des zweiten Halbleiterkörpers mit einer Anschlussstelle des Anschlussträgers über eine Leiterbahn des Anschlussträgers verbunden, die sich stellenweise unterhalb des Halbleiterkörpers erstreckt und stellenweise lateral beabstandet zum Halbleiterkörper ist. Mit anderen Worten ist über die Leiterbahn des Anschlussträgers ein Kontakt des Halbleiterkörpers in lateraler Richtung in einem Bereich des Anschlussträgers gezogen, der vom Halbleiterkörper unbedeckt ist. Dies erlaubt eine besonders einfache Kontaktierung der Anschlussstellen des Anschlussträgers.

Gemäß zumindest einer Ausführungsform sind mehrere Paare erster Halbleiterkörper und zweiter Halbleiterkörper mittels Leiterbahnen des Anschlussträgers elektrisch leitend miteinander verbunden. Das heißt, das optoelektronische Halbleiterbauteil umfasst zumindest zwei Paare erster Halbleiterkörper und zweiter Halbleiterkörper, wobei die ersten Halbleiterkörper miteinander in Reihe geschaltet sind und jedem ersten Halbleiterkörper sein zweiter Halbleiterkörper antiparallel geschaltet ist. Auf diese Weise ergibt sich eine Reihenschaltung von beispielsweise Leuchtdiodenchips, die jeweils durch ihre zugehörige ESD-Schutzdiode abgesichert sind. Die Verschaltung der einzelnen ersten Halbleiterkörper erfolgt dabei durch die Leiterbahnen des Anschlussträgers, die beispielsweise entsprechende Anschlussstellen des Anschlussträgers miteinander verbinden.

Erfindungsgemäss ist auf der dem Anschlussträger abgewandten Oberseite des zweiten Halbleiterkörpers eine elektrisch leitende Schicht angeordnet. Die elektrisch leitende Schicht erhöht die Querleitfähigkeit der p-leitenden Schicht im zweiten Halbeiterkörper. Dabei ist es möglich, dass sich eine Durchkontaktierung durch die n-leitende Schicht und die p-leitende Schicht des zweiten Halbleiterkörpers bis zur elektrisch leitenden Schicht erstreckt. Die elektrisch leitenden Schicht ist zum Beispiel mit einem Metall wie Gold gebildet. Die elektrisch leitenden Schicht kann insbesondere strahlungsundurchlässig ausgebildet sein. Im Betrieb wird im zweiten Halbleiterkörper 2 keine Strahlung erzeugt oder diese wird vorteilhaft von der elektrisch leitenden Schicht am Austritt gehindert.

Im Folgenden werden das hier beschriebene Verfahren sowie das hier beschriebene Halbleiterbauteil anhand von Ausführungsbeispielen und den dazugehörigen Figuren näher erläutert.
Die Figuren 1A, 1B, 1C, 1D, 1E, 1F zeigen anhand schematischer Ansichten Halbleiterkörper und Ausschnitte von Halbleiterkörpern von Beispielen von hier beschriebenen optoelektronischen Halbleiterbauteilen, die jeweils zum Verständnis der Erfindung dienen sollen.
Die Figuren 2A, 2B, 2C, 4A, 4B, 5A, 5B und 5C zeigen schematische Ansichten von Beispielen eines optoelektronischen Halbleiterbauteils, die jeweils zum Verständnis der Erfindung dienen sollen.
Die Figuren 3A und 3B zeigen schematische Ansichten eines erfindungsgemäßen Ausführungsbeispiels eines hier beschriebenen optoelektronischen Halbleiterbauteils.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

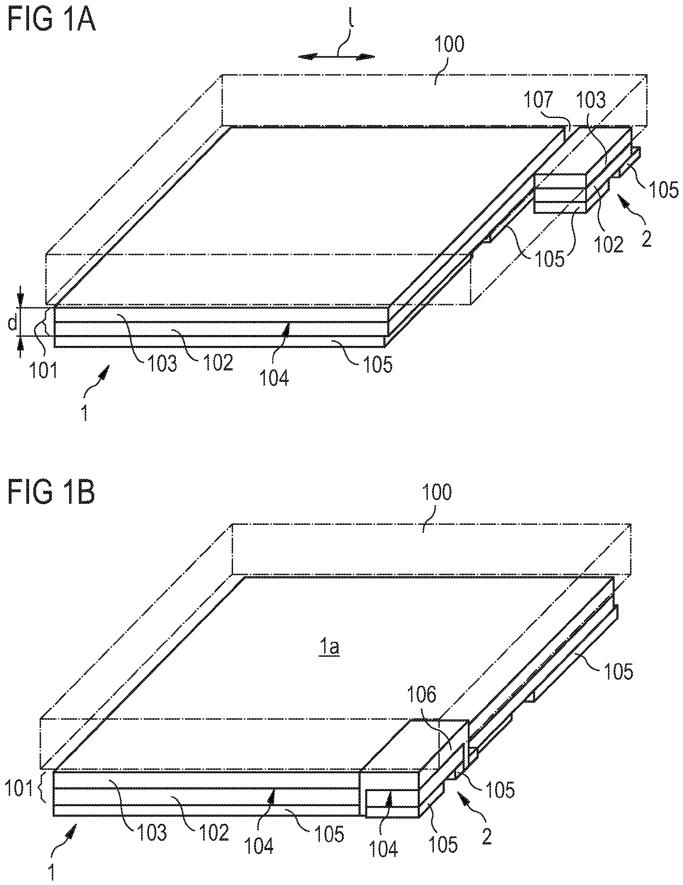

Die Figur 1A zeigt eine perspektivische Ansicht eines Paares mit einem ersten Halbleiterkörper 1 und einem zweiten Halbleiterkörper 2 eines hier beschriebenen optoelektronischen Halbleiterbauteils vor dem Ablösen des Substrats 100. Auf dem Substrat 100, das beispielsweise Saphir oder Silizium umfasst, ist der Halbleiterschichtenstapel 101 epitaktisch abgeschieden. Der Halbleiterschichtenstapel 101 umfasst eine p-leitende Schicht 102 und eine n-leitende Schicht 103. Zwischen der p-leitenden Schicht und der n-leitenden Schicht ist der pn-Übergang 104 angeordnet, der beispielsweise zumindest einen zur Erzeugung von elektromagnetischer Strahlung geeigneten Bereich umfasst.

Der Halbleiterschichtenstapel ist vorliegend in lateraler Richtung 1 in den ersten Halbleiterkörper 1 und den zweiten Halbleiterkörper 2 strukturiert. Der erste Halbleiterkörper 1 weist dabei eine Grundfläche auf, die wenigstens zehn Mal so groß ist wie die Grundfläche des zweiten Halbleiterkörpers.

Erster Halbleiterkörper 1 und zweiter Halbleiterkörper 2 sind vorliegend durch einen Graben 107 voneinander getrennt, der sich von der dem Substrat 100 abgewandten Seite des Halbleiterschichtenstapels 101 bis zum Substrat 100 erstreckt.

Auf der dem Substrat 100 abgewandten Seite des Halbleiterschichtenstapels 101 sind elektrische Kontaktstellen 105 beispielsweise in Form von Metallisierungen strukturiert. Die Kontaktstellen 105 dienen zum n- beziehungsweise p-seitigen Kontaktieren der Halbleiterkörper 1, 2.

Im Beispiel der Figur 1A ist der zweite Halbleiterkörper 2 lateral beabstandet zum ersten Halbleiterkörper 1 außerhalb dessen Fläche angeordnet. Der zweite Halbleiterkörper 2 weist beispielsweise eine Breite von 60 µm und eine Länge von 100 µm auf. Der erste Halbleiterkörper 1 kann eine Breite und eine Länge von beispielsweise jeweils 1 mm aufweisen.

Im fertigen optoelektronischen Halbleiterbauteil dient der erste Halbleiterkörper 1 als Leuchtdiodenchip zur Erzeugung von elektromagnetischer Strahlung, beispielsweise von Licht. Der zweite Halbleiterkörper 2 dient als ESD-Schutzdiode. Erster Halbleiterkörper 1 und zweiter Halbleiterkörper 2 sind vorliegend durch die Bildung des Schichtenstapels 101 gemeinsam auf dem Substrat 100 ausgebildet und weisen daher im Wesentlichen die gleiche Dicke und die gleiche Zusammensetzung auf. "Im Wesentlichen" heißt dabei, dass sich erster und zweiter Halbleiterkörper in Zusammensetzung und Dicke aufgrund von herstellungsbedingten Schwankungen unterscheiden können.

Beispielsweise beträgt die Dicke für den ersten und zweiten Halbleiterkörper, also die Dicke des Halbleiterschichtenstapels 101 d ≤ 10 µm, zum Beispiel d = 6 µm.

In Verbindung mit der schematischen perspektivischen Darstellung der Figur 1B ist ein weiteres Paar eines ersten Halbleiterkörpers 1 und eines zweiten Halbleiterkörpers 2 für ein Beispiel eines hier beschriebenen optoelektronischen Halbleiterbauteils gezeigt. Im Unterschied zum Beispiel der Figur 1A ist der zweite Halbleiterkörper 2 hier in der Fläche des ersten Halbleiterkörpers 1 angeordnet. Auf diese Weise wird möglichst wenig Material des epitaktisch hergestellten Halbleiterschichtenstapels verschwendet. Zur besseren elektrischen Trennung ist der Graben 107 zwischen dem ersten Halbleiterkörper 1 und dem zweiten Halbleiterkörper 2 mit dem elektrisch isolierenden Material 106, beispielsweise Siliziumnitrid und/oder Siliziumdioxid, gefüllt.

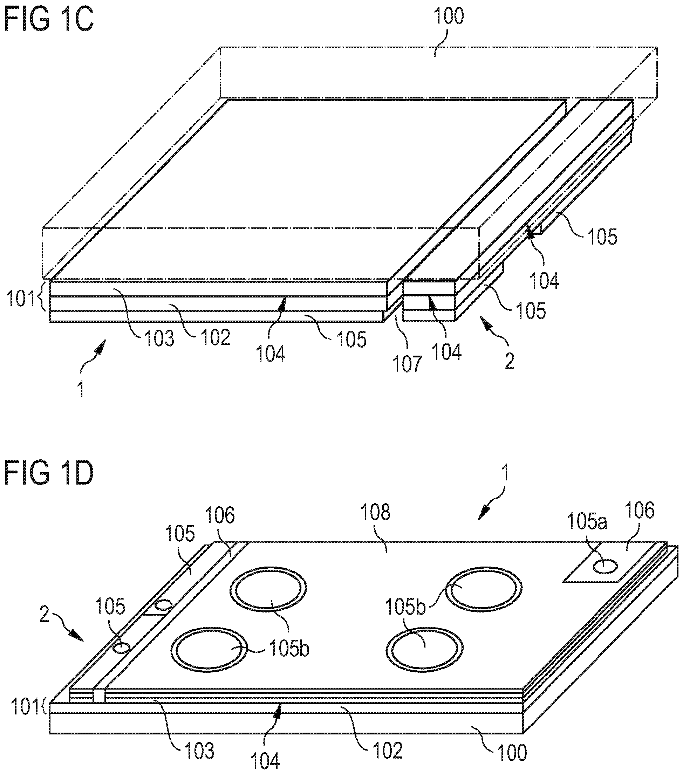

In Verbindung mit der schematischen Perspektivdarstellung der Figur 1C ist ein weiteres Beispiel des Paares von erstem und zweitem Halbleiterkörper für ein Beispiel eines hier beschriebenen optoelektronischen Halbleiterbauteils gezeigt. In diesem Ausführungsbeispiel erstreckt sich der zweite Halbleiterkörper, der durch den Graben 107 vom ersten Halbleiterkörper 101 getrennt ist, entlang der gesamten Chipflanke des ersten Halbleiterkörpers 1. In diesem Fall kann der zweite Halbleiterkörper 2 eine ESD-Schutzdiode für den ersten Halbleiterkörper 1 bilden, die besonders widerstandsfähig ist.

In Verbindung mit der schematischen Perspektivdarstellung der Figur 1D ist ein Beispiel zur Ausführung des Paares von erstem Halbleiterkörper und zweitem Halbleiterkörper näher erläutert. Die Figur 1D zeigt dabei eine Ansicht auf die dem Substrat 100 abgewandte Seite der Halbleiterkörper 1, 2. Im Bereich des ersten Halbleiterkörpers 1 sind beispielsweise p-seitige Kontaktstellen 105b angeordnet. In einem Randbereich des ersten Halbleiterkörpers 1 kann eine Kontaktstelle 105a zur n-seitigen Kontaktierung angeordnet sein. Der Halbleiterkörper 1 kann an seiner dem Substrat 100 abgewandten Seite eine Rückseitenmetallisierung 108 aufweisen, die beispielsweise durch folgende Schichtenfolge gebildet ist: Ti/Pt/Au. Zwischen der Rückseitenmetallisierung 108 und dem p-leitenden Bereich 102 kann beispielsweise eine Schichtenfolge angeordnet sein, die Silber enthält oder aus Silber besteht und als Spiegel wirkt. Die Schichtenfolge ist beispielsweise wie folgt aufgebaut: Pt/Ag/Ti.

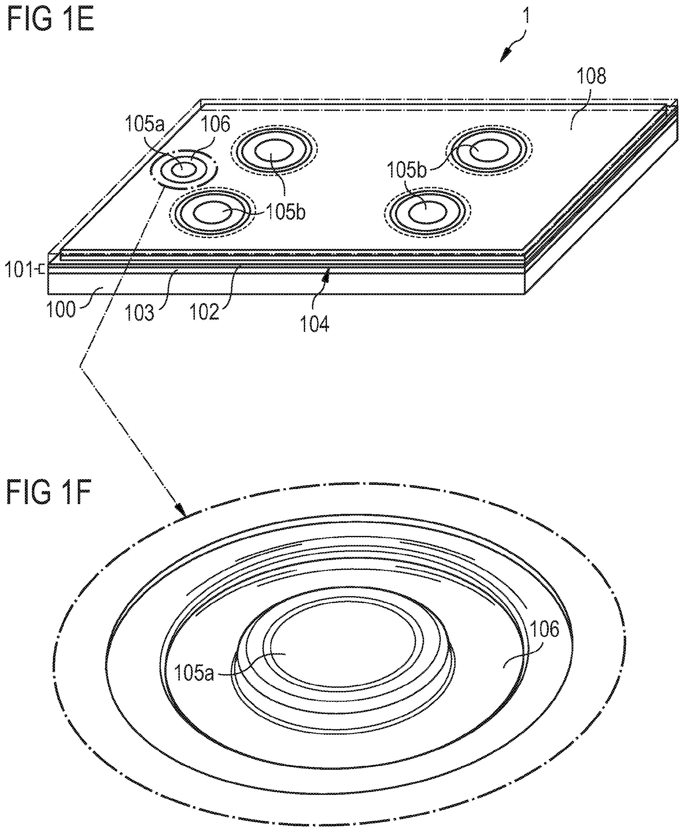

In Verbindung mit der schematischen Perspektivdarstellung der Figur 1E ist näher dargestellt, dass die n-Kontaktstelle 105a beispielsweise als Durchkontaktierung durch die p-leitende Schicht 102 ausgebildet sein kann, die mit einem elektrisch isolierenden Material 106, beispielsweise Siliziumdioxid, vom restlichen Halbleiterkörper isoliert ist (siehe dazu auch die Ausschnittsvergrößerung der Figur 1F).

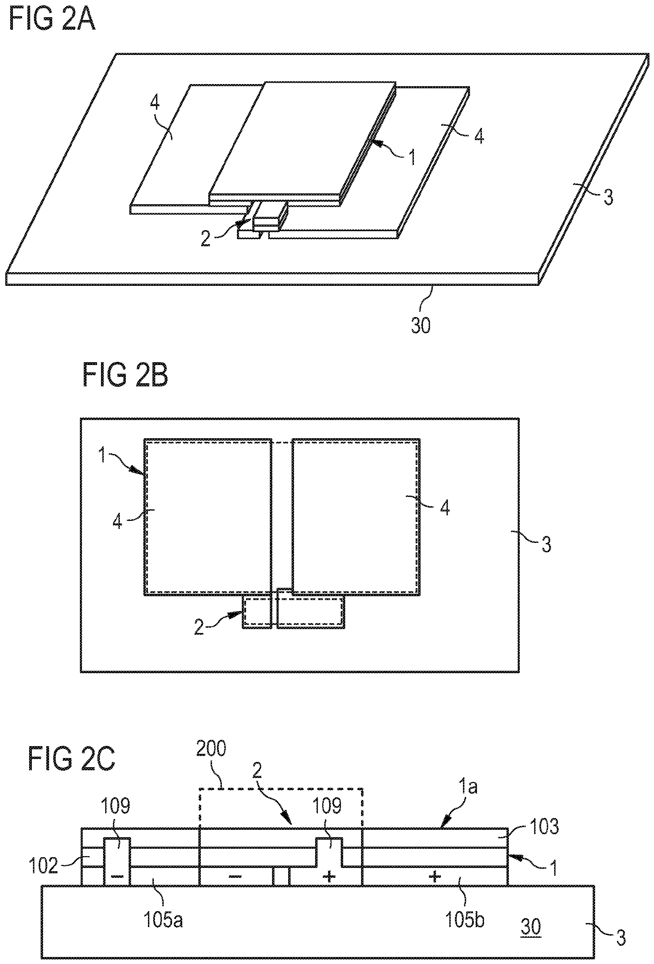

Anhand der schematischen Ansichten der Figuren 2A, 2B und 2C ist ein erstes Beispiel eines hier beschriebenen optoelektronischen Halbleiterbauteils näher erläutert. Bei dem optoelektronischen Halbleiterbauteil kommt beispielsweise ein Paar erster Halbleiterkörper 1 und zweiter Halbleiterkörper 2, wie in Verbindung mit einer der Figuren 1A bis 1F beschrieben, zum Einsatz. Das optoelektronische Halbleiterbauteil umfasst einen Anschlussträger 3. Der Anschlussträger 3 umfasst einen keramischen Grundkörper 30, der mit einem keramischen Material gebildet ist. Beispielsweise handelt es sich bei dem keramischen Material um Siliziumnitrid, Aluminiumoxid oder Bornitrid.

Auf der den Halbleiterkörpern 1, 2 zugewandten Seite des Anschlussträgers 3 sind im Beispiel der Figuren 2A, 2B zwei Anschlussstellen 4 angeordnet (siehe dazu insbesondere die schematische Draufsicht der Figur 2B). An den Anschlussstellen 4 sind die Halbleiterkörper 1, 2 beispielsweise aufgelötet. Der als ESD-Schutzdiode vorgesehene Halbleiterkörper 2 ist dem zur Strahlungserzeugung vorgesehenen Halbleiterkörper 1 antiparallel geschaltet. Das heißt, die pn-Übergänge 104 der beiden Halbleiterkörper 1, 2 sind über die Anschlussstellen 4 des Anschlussträgers 3 antiparallel zueinander geschaltet.

Die Halbleiterkörper 1, 2 sind dabei in der gleichen Orientierung auf den Anschlussträger 3 aufgebracht. Das heißt, bei beiden Halbleiterkörpern 1, 2 ist beispielsweise die n-leitende Schicht 103 vom Halbleiterkörper 3 weg gerichtet.

Anhand der schematischen Seitenansicht der Figur 2C ist erläutert, dass sich eine Durchkontaktierung 109 im ersten Halbleiterkörper 1 und im zweiten Halbleiterkörper 2 jeweils durch die p-leitende Schicht 102 hindurch in die n-leitende Schicht 103 erstreckt. Auf diese Weise sind der erste und der zweite Halbleiterkörper 1,2 oberflächenmontierbar.

Die dem Anschlussträger 3 abgewandten Oberflächen der Halbleiterkörper 1,2 sind frei von Kontaktstellen oder elektrischen Leitern.

Wie aus der Figur 2C ersichtlich ist, kann jedoch auf der dem Anschlussträger 3 abgewandten Oberseite des zweiten Halbleiterkörpers 2 eine elektrisch leitende Schicht 200 angeordnet sein. Die elektrisch leitende Schicht 200 erhöht die Querleitfähigkeit der p-leitenden Schicht 103 im zweiten Halbeiterkörper 2. Dabei ist es möglich, dass sich die Durchkontaktierung 109 bis zur elektrisch leitenden Schicht 200 erstreckt. Die elektrisch leitenden Schicht 200 ist zum Beispiel mit einem Metall wie Gold gebildet. Die elektrisch leitenden Schicht 200 kann insbesondere strahlungsundurchlässig ausgebildet sein.

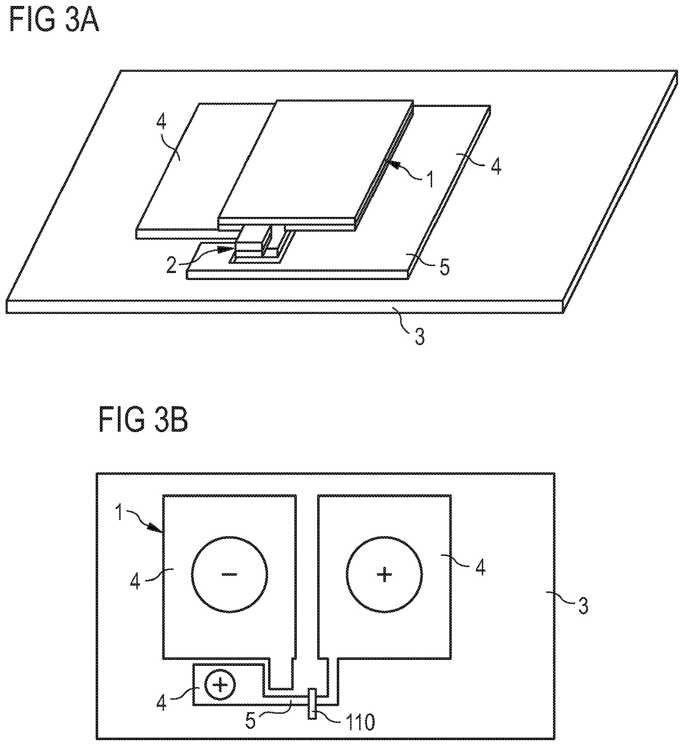

In Verbindung mit den Figuren 3A, 3B ist ein Ausführungsbeispiel eines hier beschriebenen optoelektronischen Halbleiterbauteils näher erläutert. Im Unterschied zum Beispiel der Figuren 2A, 2B sind die Halbleiterkörper 1, 2 in diesem Ausführungsbeispiel durch die Anschlussstellen 4 und eine Leiterbahn 5 des Anschlussträgers 3 antiparallel zueinander geschaltet. Die Leiterbahn 5 weist dabei ursprünglich, also unmittelbar nach dem Aufbringen der Halbleiterkörper 1, 2 eine Unterbrechung 110 auf. Mit anderen Worten sind der erste Halbleiterkörper 1 und der zweite Halbleiterkörper 2 unmittelbar nach ihrem Aufbringen auf den Anschlussträger 3 nicht antiparallel zueinander geschaltet. Der zweite Halbleiterkörper 2 wirkt daher zunächst nicht als ESD-Schutzdiode für den strahlungsemittierenden Halbleiterkörper 1. In diesem Zustand wird der Halbleiterkörper 1 auf seine Funktionstüchtigkeit hin getestet. Nach dem Testen wird die Unterbrechung 110 beispielsweise mittels Siebdruck oder Dispensen einer elektrisch leitfähigen Paste geschlossen. Das heißt, der erste Halbleiterkörper 1 und der zweite Halbleiterkörper 2 sind nach dem Testen des ersten Halbleiterkörpers 1 antiparallel zueinander geschaltet, sodass der zweite Halbleiterkörper 2 seine Funktion als ESD-Schutzdiode für den ersten Halbleiterkörper 1 wahrnehmen kann.

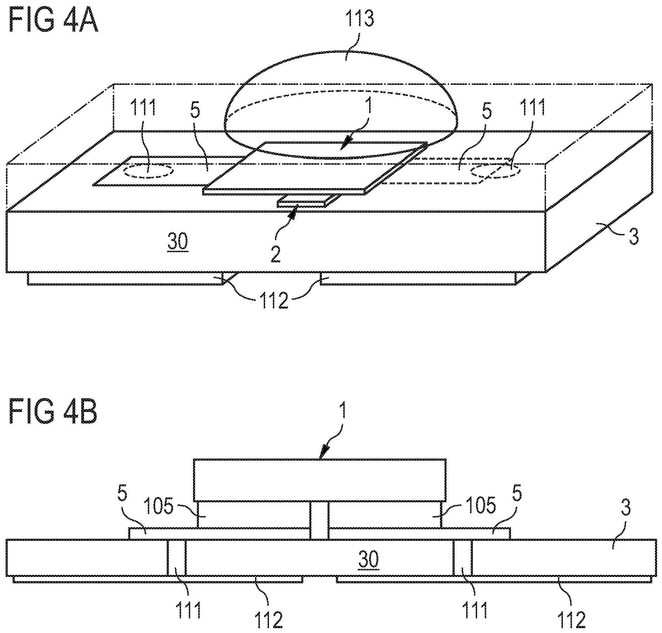

Die schematischen Ansichten der Figuren 4A und 4B zeigen ein weiteres Beispiel eines hier beschriebenen optoelektronischen Halbleiterbauteils. Das in den Figuren 4A und 4B beschriebene optoelektronische Halbleiterbauteil ist mittels der externen Anschlussstellen 112 oberflächenmontierbar. Im Grundkörper 30 des Anschlussträgers 3 sind Durchkontaktierungen 111 angeordnet, welche die Oberseite des Grundkörpers 30 mit den Halbleiterkörpern 1, 2 mit der den Halbleiterkörpern 1, 2 abgewandten Unterseite verbindet. Mittels der Durchkontaktierungen 111 ist eine elektrisch leitende Verbindung zwischen den externen Anschlussstellen 112 und den Leiterbahnen 5 an der Oberseite des Grundkörpers 30 des Anschlussträgers 3 hergestellt (siehe dazu insbesondere die schematische Schnittdarstellung der Figur 4B).

Die Leiterbahnen 5 sind mit Kontaktstellen 105 des ersten Halbleiterkörpers 1 und des zweiten Halbleiterkörpers 2 elektrisch leitend verbunden. Die beiden Halbleiterkörper sind über die Leiterbahnen 5 antiparallel zueinander geschaltet. Die Halbleiterkörper 1 sind ferner mit einem strahlungsdurchlässigen Verguss 113, der beispielsweise Silikon und/oder Epoxid enthält, formschlüssig umgeben. Der Verguss 113 schließt an den lateralen Seitenflächen des Halbleiterbauteils bündig mit dem Grundkörper 30 des Anschlussträgers 3 ab. Im Bereich des ersten Halbleiterkörpers 1 kann der Verguss 113 zur Erhöhung der Strahlungsaustrittseffizienz linsenartig konvex nach außen, vom Anschlussträger 3 weg, gekrümmt sein.

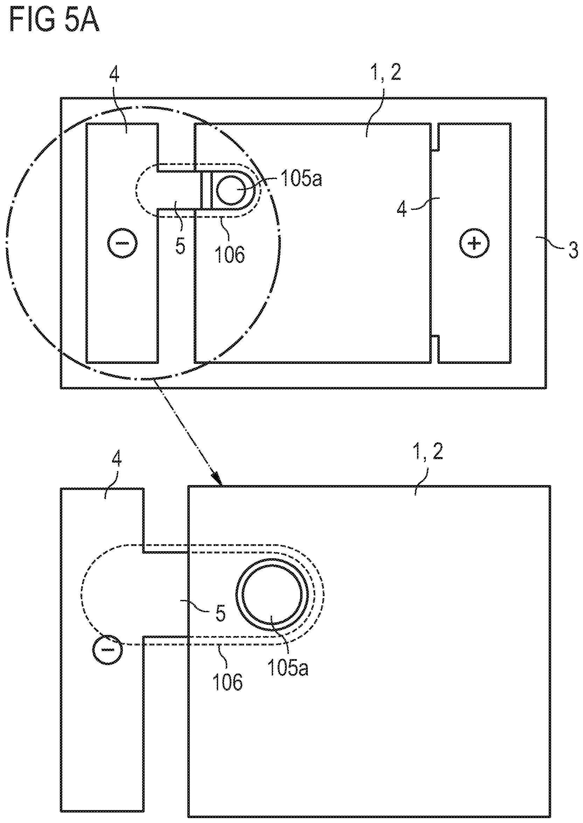

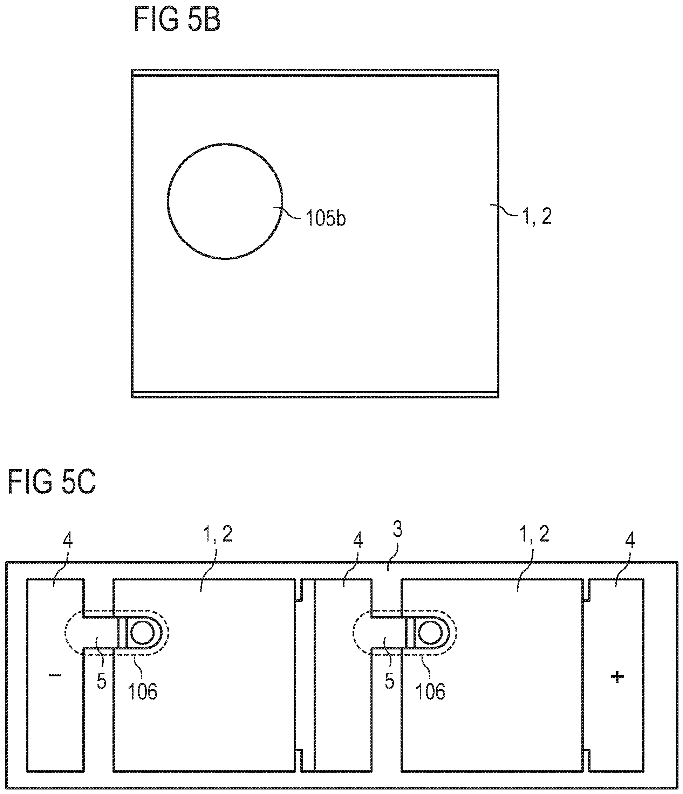

In Verbindung mit den Figuren 5A, 5B, 5C sind anhand schematischer Draufsichten weitere Beispiele von hier beschriebenen optoelektronischen Halbleiterbauteilen näher erläutert. Den Beispielen ist dabei gemeinsam, dass beispielsweise die n-Kontaktstelle 105a zumindest des ersten Halbleiterkörpers 1 mittels einer Leiterbahn 5, die beispielsweise als Metallisierung ausgebildet ist, mit einer zugeordneten Anschlussstelle 4 des Anschlussträgers 3 verbunden ist. Die Leiterbahn 5 erstreckt sich zumindest stellenweise unterhalb des ersten Halbleiterkörpers 1, also zwischen Grundkörper 30 des Anschlussträgers 3 und der dem Anschlussträger 3 zugewandten Unterseite des Halbleiterkörpers 1. Zwischen der Leiterbahn 5 und dem Halbleiterkörper 1 ist ein elektrisch isolierendes Material 106, beispielsweise eine Schicht aus Siliziumdioxid und/oder Siliziumnitrid angeordnet.

In Verbindung mit der Figur 5B ist gezeigt, dass die verbleibende Unterseite des Halbleiterkörpers dann beispielsweise als p-seitige Kontaktstelle 105b dienen kann. Mittels der Leiterbahn 5 ist die Kontaktierung für den Halbleiterkörper 1, 2 lateral unterhalb des Halbleiterkörpers nach außen gezogen. Wie in der Figur 5C gezeigt, kann eine solche Anordnung besonders gut zur Reihenschaltung von ersten Halbleiterkörpern 1 mit antiparallel geschalteten zweiten Halbleiterkörpern 2 genutzt werden.

Bei allen Ausführungsbeispielen und Beispielen ist es auch möglich, dass die Kontaktstelle 105b eine n-seitige Kontaktstelle bildet und die Kontaktstelle 105a eine p-seitige Kontaktstelle bildet.

Insgesamt zeichnet sich ein hier beschriebenes optoelektronisches Halbleiterbauteil durch seine kostengünstige Herstellbarkeit, seinen flachen, Platz sparenden Aufbau sowie seine flexiblen Einsatzmöglichkeiten aus.

Die Erfindung ist nicht durch die Beschreibung anhand der Ausführungsbeispiele auf diese beschränkt.

## Patentansprüche

1. Verfahren zur Herstellung eines optoelektronischen Halbleiterbauteils mit den folgenden Schritten
- Anordnen eines Halbleiterschichtenstapels (101) mit einem pn-Übergang (104) auf einem Substrat (100),
- laterales Strukturieren des Halbleiterschichtenstapels (101) in eine Vielzahl von Paaren erster Halbleiterkörper (1) und zweiter Halbleiterkörper (2), die in lateraler Richtung(l) beabstandet zueinander sind,
- Ablösen des Substrats (100) von den Paaren erster Halbleiterkörper (1) und zweiter Halbleiterkörper (2),
- Aufbringen zumindest eines Paars erster Halbleiterkörper (1) und zweiter Halbleiterkörper (2) auf einen Anschlussträger (3), der elektrische Anschlussstellen (4) und zumindest eine Leiterbahn (5) aufweist, wobei der erste Halbleiterkörper (1) im Betrieb des Halbleiterbauteils zur Erzeugung von elektromagnetischer Strahlung vorgesehen ist, und der zweite Halbleiterkörper (2) als ESD-Schutzdiode für den ersten Halbleiterkörper (1) vorgesehen ist,
- elektrisches Verbinden der Halbleiterkörper eines Paars erster Halbleiterkörper (1) und zweiter Halbleiterkörper (2) mittels der Anschlussstellen (4) und der zumindest einen Leiterbahn (5), derart dass der pn-Übergang (104) des ersten Halbleiterkörpers (1) zum pn-Übergang (104) des zweiten Halbleiterkörpers (2) antiparallel geschaltet ist,
- wobei auf der dem Anschlussträger (3) abgewandten Oberseite des zweiten Halbleiterkörpers (2) eine elektrisch leitende, metallische Schicht (200) angeordnet wird,
- wobei die zumindest eine Leiterbahn (5) zum elektrischen Verbinden des ersten Halbleiterkörpers (1) mit dem zweiten Halbleiterkörper (2) erst nach dem Aufbringen und einem Testen des ersten Halbleiterkörpers (1) geschlossen wird, und die zumindest eine Leiterbahn (5) unmittelbar nach dem Aufbringen der Halbleiterkörper (1, 2) eine Unterbrechung (110) aufweist, wobei die Unterbrechung (110) nach dem Testen auf die Funktionstüchtigkeit des ersten Halbleiterkörpers (1) mittels einer elektrisch leitfähigen Paste geschlossen wird.

2. Verfahren nach Anspruch 1,
wobei das Ablösen des Substrats (100) nach dem Aufbringen zumindest eines Paars erster Halbleiterkörper (1) und zweiter Halbleiterkörper (2) auf den Anschlussträger (3) erfolgt.

3. Verfahren nach einem der vorherigen Ansprüche mit mehreren Paaren erster Halbleiterkörper (1) und zweiter Halbleiterkörper (2), die mittels Leiterbahnen (5) des Anschlussträgers (3) elektrisch leitend miteinander verbunden werden.

4. Optoelektronisches Halbleiterbauteil mit
- einem Anschlussträger (3), der elektrische Anschlussstellen (4) und zumindest eine Leiterbahn (5) aufweist,
- einem ersten Halbleiterkörper (1), der eine p-leitende Schicht (102), eine n-leitende Schicht (103) und einen pn-Übergang (104) aufweist,
- einem zweiten Halbleiterkörper (2), der eine p-leitende Schicht (102), eine n-leitende Schicht (103) und einen pn-Übergang (104) aufweist, wobei der erste Halbleiterkörper (1) im Betrieb des Halbleiterbauteils zur Erzeugung von elektromagnetischer Strahlung vorgesehen ist, und der zweite Halbleiterkörper (2) als ESD-Schutzdiode für den ersten Halbleiterkörper (1) vorgesehen ist, und
- einer Durchkontaktierung (109) im ersten Halbleiterkörper (1) und einer Durchkontaktierung (109) im zweiten Halbleiterkörper (2), wobei
- sich die Durchkontaktierungen zur Kontaktierung der n-leitenden Schicht der Halbleiterkörper jeweils durch die p-leitende Schicht hindurch in die n-leitende Schicht erstrecken und mit einem elektrisch isolierenden Material (106) vom restlichen Halbleiterkörper isoliert sind,
- der erste Halbleiterkörper (1) und der zweite Halbleiterkörper (2) eine gleiche Abfolge von Halbleiterschichten umfassen,
- der erste Halbleiterkörper (1) und der zweite Halbleiterkörper (2) die gleiche Dicke (d) aufweisen,
- der erste Halbleiterkörper (1) und der zweite Halbleiterkörper (2) mit zugeordneten elektrischen Anschlussstellen (4) leitend verbunden sind, und
- der erste Halbleiterkörper (1) und der zweite Halbleiterkörper (2) mittels der elektrischen Anschlussstellen (4) und der zumindest einen Leiterbahn (5) derart verbunden sind, dass der pn-Übergang (104) des ersten Halbleiterkörpers (1) zum pn-Übergang (104) des zweiten Halbleiterkörpers (2) antiparallel geschaltet ist,
- wobei auf der dem Anschlussträger abgewandten Oberseite des zweiten Halbleiterkörpers (2) eine elektrisch leitende, metallische Schicht (200) angeordnet ist, wobei sich die Durchkontaktierung (109) bis zur elektrisch leitenden Schicht (200) erstreckt, und
- wobei die zumindest eine Leiterbahn (5) eine Unterbrechung (110) aufweist, welche mit einer elektrisch leitfähigen Paste geschlossen ist.

5. Optoelektronisches Halbleiterbauteil nach Anspruch 4, bei dem eine Grundfläche des ersten Halbleiterkörpers (1) größer ist als eine Grundfläche des zweiten Halbleiterkörpers (2).

6. Optoelektronisches Halbleiterbauteil nach einem der Ansprüche 4 oder 5,
bei dem der erste Halbleiterkörper (1) und der zweite Halbleiterkörper (2) eine Dicke (d) von höchstens 10 µm aufweisen.

7. Optoelektronisches Halbleiterbauteil nach einem der Ansprüche 4 bis 6,
bei dem der erste Halbleiterkörper (1) und der zweite Halbleiterkörper (2) oberflächenmontierbar sind, wobei
- der erste Halbleiterkörper (1) und der zweite Halbleiterkörper (2) an ihren dem Anschlussträger (3) zugewandten Bodenflächen Kontaktstellen (105) aufweisen.

8. Optoelektronisches Halbleiterbauteil nach einem der Ansprüche 4 bis 7,
bei dem der erste Halbleiterkörper (1) an seiner dem Anschlussträger (3) abgewandten Oberseite eine Strahlungsaustrittsfläche (1a) aufweist, wobei der erste Halbleiterkörper (1) an der Oberseite frei von Metallisierungen, Kontaktstellen und Stromverteilungsbahnen ist und eine Stromverteilung zur Bestromung des pn-Übergangs (104) des ersten Halbleiterkörpers (1) vollständig unterhalb der Strahlungsaustrittsfläche (1a) erfolgt.

9. Optoelektronisches Halbleiterbauteil nach einem der Ansprüche 4 bis 8,
bei dem der Anschlussträger (3) einen keramischen Grundkörper (30) umfasst, an dessen Außenflächen die Anschlussstellen (4, 112) und/oder die zumindest eine Leiterbahn (5) als strukturierte Metallisierungen aufgebracht sind.

10. Optoelektronisches Halbleiterbauteil nach einem der Ansprüche 4 bis 9 mit mehreren Paaren erster Halbleiterkörper (1) und zweiter Halbleiterkörper (2), die mittels Leiterbahnen (5) des Anschlussträgers (3) elektrisch leitend miteinander verbunden sind.

## Claims

1. A method of manufacturing an optoelectronic semiconductor device comprising the following steps
- arranging a semiconductor layer stack (101) having a pn junction (104) on a substrate (100),
- laterally structuring said semiconductor layer stack (101) into a plurality of pairs of first semiconductor bodies (1) and second semiconductor bodies (2) spaced apart from each other in a lateral direction (1),
- separating the substrate (100) from the pairs of first semiconductor bodies (1) and second semiconductor bodies (2),
- applicating of at least one pair of first semiconductor bodies (1) and second semiconductor bodies (2) to a connection carrier (3) which has electrical connection points (4) and at least one conductor track (5), the first semiconductor body (1) being provided during operation of the semiconductor component for generating electromagnetic radiation, and the second semiconductor body (2) being provided as an ESD protective diode for the first semiconductor body (1),
- electrically connecting of the semiconductor bodies of a pair of first semiconductor bodies (1) and second semiconductor bodies (2) by means of the connection points (4) and the at least one conductor track (5) in such a way that the pn-junction (104) of the first semiconductor body (1) is connected antiparallel to the pn-junction (104) of the second semiconductor body (2),
- wherein an electrically conductive, metallic layer (200) is arranged on the upper side of the second semiconductor body (2) facing away from the connection carrier (3),
- wherein the at least one conductor track (5) for electrically connecting the first semiconductor body (1) to the second semiconductor body (2) is closed only after the application and testing of the first semiconductor body (1), and the at least one conductor track (5) has an interruption (110) immediately after the application of the semiconductor bodies (1, 2), wherein the interruption (110) is closed after the testing for the functional capability of the first semiconductor body (1) by means of an electrically conductive paste.

2. Method according to claim 1,
Where the substrate (100) is detached after at least one pair of first semiconductor bodies (1) and second semiconductor bodies (2) have been applied to the connection carrier (3).

3. Method according to one of the preceding claims having a plurality of pairs of first semiconductor bodies (1) and second semiconductor bodies (2) which are electrically conductively connected to one another by means of conductor tracks (5) of the terminal carrier (3).

4. Optoelectronic semiconductor component with
- a connection carrier (3) which has electrical connection points (4) and at least one conductor track (5),
- a first semiconductor body (1) comprising a p-type layer (102), an n-type layer (103) and a pn junction (104),
- a second semiconductor body (2) which has a p-type layer (102), an n-type layer (103) and a pn junction (104), the first semiconductor body (1) being provided for generating electromagnetic radiation during operation of the semiconductor component, and the second semiconductor body (2) being provided as an ESD protective diode for the first semiconductor body (1), and
- a via (109) in the first semiconductor body (1) and a via (109) in the second semiconductor body (2), wherein
- the vias for contacting the n-conducting layer of the semiconductor bodies each extend through the p-conducting layer into the n-conducting layer and are insulated from the remaining semiconductor body with an electrically insulating material (106),
- the first semiconductor body (1) and the second semiconductor body (2) comprise a same sequence of semiconductor layers,
- the first semiconductor body (1) and the second semiconductor body (2) have the same thickness (d),
- the first semiconductor body (1) and the second semiconductor body (2) are conductively connected to associated electrical connection points (4), and
- the first semiconductor body (1) and the second semiconductor body (2) are connected by means of the electrical connection points (4) and the at least one conductor track (5) in such a way that the pn-junction (104) of the first semiconductor body (1) is connected antiparallel to the pn-junction (104) of the second semiconductor body (2),
- wherein an electrically conductive metallic layer (200) is arranged on the upper side of the second semiconductor body (2) facing away from the terminal carrier, wherein the through-plating (109) extends as far as the electrically conductive layer (200), and wherein the through-plating (109) is arranged on the upper side of the second semiconductor body (2) facing away from the terminal carrier.
- wherein the at least one conductor track (5) has an interruption (110) which is closed with an electrically conductive paste.

5. Optoelectronic semiconductor component according to claim 4,
wherein a base area of said first semiconductor body (1) is larger than a base area of said second semiconductor body (2).

6. Optoelectronic semiconductor device conforming to any of claims 4 or 5,
in which the first semiconductor body (1) and the second semiconductor body (2) have a thickness (d) of at most 10 µm.

7. Optoelectronic semiconductor device conforming to any of claims 4 to 6,
in which the first semiconductor body (1) and the second semiconductor body (2) are surface mountable, wherein
- the first semiconductor body (1) and the second semiconductor body (2) have contact points (105) on their bottom surfaces facing the connection carrier (3).

8. Optoelectronic semiconductor component in accordance with one of claims 4 to 7,
in which the first semiconductor body (1) has a radiation exit surface (1a) on its upper side remote from the connection carrier (3), the upper side of the first semiconductor body (1) being free from metallizations, contact points and current distribution paths, and a current distribution for supplying current to the pn-junction (104) of the first semiconductor body (1) taking place completely below the radiation exit surface (1a).

9. Optoelectronic semiconductor component in accordance with one of claims 4 to 8,
in which the connection carrier (3) comprises a ceramic base body (30), on the outer surfaces of which the connection points (4, 112) and/or the at least one conductor track (5) are applied as structured metallizations.

10. Optoelectronic semiconductor component according to one of claims 4 to 9 having a plurality of pairs of first semiconductor bodies (1) and second semiconductor bodies (2) which are electrically conductively connected to one another by means of conductor tracks (5) of the terminal carrier (3).

## Revendications

1. Procédé de fabrication d'un composant semi-conducteur optoélectronique, comprenant les étapes suivantes
- mise en place d'un empilement de couches semi-conductrices (101) présentant une jonction p-n (104) sur un substrat (100),
- structuration latérale de l'empilement de couches semi-conductrices (101) en une pluralité de paires de premiers corps semi-conducteurs (1) et seconds corps semi-conducteurs (2) espacés les uns des autres dans le sens latéral (1),
- retrait du substrat (100) des paires de premiers corps semi-conducteurs (1) et seconds corps semi-conducteurs (2),
- installation d'au moins une paire de premiers corps semi-conducteurs (1) et seconds corps semi-conducteurs (2) sur un support de raccordement (3) présentant des bornes de raccordement électrique (4) et au moins une piste conductrice (5), le premier corps semi-conducteur (1) étant prévu pour générer un rayonnement électromagnétique durant le fonctionnement du composant semi-conducteur et le second corps semi-conducteur (2) étant prévu en tant que diode de protection sensible aux décharges électrostatiques pour le premier corps semi-conducteur (1),
- raccordement électrique des corps semi-conducteurs d'une paire de premiers corps semi-conducteurs (1) et seconds corps semi-conducteurs (2) au moyen des bornes de raccordement (4) et d'au moins une piste conductrice (5), de manière que la jonction p-n (104) du premier corps semi-conducteur (1) soit connectée antiparallèlement à la jonction p-n (104) du second corps semi-conducteur (2),
- une couche métallique électro-conductrice (200) étant disposée sur la face supérieure du second corps semi-conducteur (2) opposée au support de raccordement (3),
- au moins une piste conductrice (5) n'étant fermée qu'après l'application et le test du premier corps semi-conducteur (1) pour assurer le raccordement électrique du premier corps semi-conducteur (1) au second corps semi-conducteur (2), et au moins une piste conductrice (5) présente une interruption (110) immédiatement après l'application des corps semi-conducteurs (1, 2), l'interruption (110) étant fermée au moyen d'une pâte électro-conductrice après le test de la capacité fonctionnelle du premier corps semi-conducteur (1).

2. Procédé selon la revendication 1,
le retrait du substrat (100) s'effectuant après l'installation d'au moins une paire de premiers corps semi-conducteurs (1) et seconds corps semi-conducteurs (2) sur le support de raccordement (3).

3. Procédé selon l'une des revendications précédentes avec plusieurs paires de premiers corps semi-conducteurs (1) et seconds corps semi-conducteurs (2), raccordées les unes aux autres en tant que conductrices d'électricité par des pistes conductrices (5) du support de raccordement (3).

4. Composant semi-conducteur optoélectronique comportant
- un support de raccordement (3) présentant des bornes de raccordement électrique (4) et au moins une piste conductrice (5),
- un premier corps semi-conducteur (1) comprenant une couche conductrice de type p (102), une couche conductrice de type n (103) et une jonction p-n (104),
- un second corps semi-conducteur (2) présentant une couche conductrice de type p (102), une couche conductrice de type n (103) et une jonction p-n (104), le premier corps semi-conducteur (1) étant prévu pour générer un rayonnement électromagnétique durant le fonctionnement du composant semi-conducteur et le second corps semi-conducteur (2) étant prévu en tant que diode de protection sensible aux décharges électrostatiques pour le premier corps semi-conducteur (1), et
- un contact traversant (109) dans le premier corps semi-conducteur (1) et un contact traversant (109) dans le second corps semi-conducteur (2),
- les contacts traversants pour mettre en contact la couche conductrice n des corps semi-conducteurs s'étendant chacun à travers la couche conductrice p jusqu'à la couche conductrice n et étant isolés du reste du corps semi-conducteur au moyen d'un matériau électro-isolant (106),
- le premier corps semi-conducteur (1) et le second corps semi-conducteur (2) comprenant une même succession de couches semi-conductrices,
- le premier corps semi-conducteur (1) et le second corps semi-conducteur (2) présentant la même épaisseur (d),
- le premier corps semi-conducteur (1) et le second corps semi-conducteur (2) étant raccordés en tant que conducteurs à des bornes de raccordement électrique affectées (4), et
- le premier corps semi-conducteur (1) et le second corps semi-conducteur (2) étant reliés au moyen des bornes de raccordement électrique (4) et d'au moins une piste conductrice (5) de telle manière que la jonction p-n (104) du premier corps semi-conducteur (1) soit connectée antiparallèlement à la jonction p-n (104) du second corps semi-conducteur (2),
- une couche métallique électro-conductrice (200) étant disposée sur la face supérieure du deuxième corps semi-conducteur (2) opposée au support de raccordement, le contact traversant (109) s'étendant jusqu'à la couche électro-conductrice (200), et
- au moins une piste conductrice (5) présentant une interruption (110) fermée au moyen d'une pâte électro-conductrice.

5. Composant semi-conducteur optoélectronique selon la revendication 4,
dans lequel une surface de base du premier corps semi-conducteur (1) est plus grande qu'une surface de base du second corps semi-conducteur (2).

6. Composant semi-conducteur optoélectronique selon l'une des revendications 4 ou 5,
dans lequel le premier corps semi-conducteur (1) et le second corps semi-conducteur (2) présentent une épaisseur (d) d'au plus 10 µm.

7. Composant semi-conducteur optoélectronique selon l'une des revendications 4 à 6,
dans lequel le premier corps semi-conducteur (1) et le second corps semi-conducteur (2) peuvent être montés en surface,
- le premier corps semi-conducteur (1) et le second corps semi-conducteur (2) présentant des points de contact (105) sur leurs surfaces inférieures faisant face au support de connexion (3).

8. Composant semi-conducteur optoélectronique selon l'une des revendications 4 à 7,
dans lequel le premier corps semi-conducteur (1) présente une surface de sortie de rayonnement (1a) sur sa face supérieure opposée au support de raccordement (3), la face supérieure du premier corps semi-conducteur (1) étant exempte de métallisations, de points de contact et de voies de distribution de courant, et une distribution de courant visant à alimenter la jonction p-n (104) du premier corps semi-conducteur (1) ayant lieu entièrement sous la surface de sortie de rayonnement (1a).

9. Composant semi-conducteur optoélectronique selon l'une des revendications 4 à 8,
dans lequel le support de raccordement (3) comprend un corps de base en céramique (30), sur les faces extérieures duquel les bornes de raccordement (4, 112) et/ou au moins une piste conductrice (5) sont installées en tant que métallisations structurées.

10. Composant semi-conducteur optoélectronique selon l'une des revendications 4 à 9 avec plusieurs paires de premiers corps semi-conducteurs (1) et de seconds corps semi-conducteurs (2), raccordé l'un à l'autre en tant que conducteurs d'électricité par des pistes conductrices (5) du support de raccordement (3).
